# FASCICULE DE BREVET EUROPEEN

(11) **EP 3 503 159 B1**
(45) Date de publication et mention de la délivrance du brevet: **05.05.2021**
(21) Numéro de dépôt: 17209168.8
(22) Date de dépôt: 20.12.2017
(51) Int. Cl.: H01J 37/32, H01J 37/317, C23C 14/48, G04B 39/00

(54) **PROCÉDÉ D'IMPLANTATION D'IONS SUR UNE SURFACE D'UN OBJET À TRAITER**
IMPLANTATIONSVERFAHREN VON IONEN IN EINE OBERFLÄCHE EINES ZU BEHANDELNDEN OBJEKTS
METHOD FOR IMPLANTING IONS ON A SURFACE OF AN OBJECT TO BE TREATED

(43) Date de publication de la demande: 26.06.2019
(60) Demande divisionnaire: 21151991.3
(73) Titulaire: The Swatch Group Research and Development Ltd, 2074 Marin (CH)
(72) Inventeur: Miko, Csilla, CH-1417 Essertines-sur-Yverdon (CH); Vuille, Pierry, 2338 Les Emibois (CH); Bazin, Jean-Luc, 2512 Tüscherz-Alfermée (CH); Kool, Arne, 1807 Blonay (CH); Boulmay, Alexis, 25500 Morteau (FR)
(74) Mandataire: ICB SA

(56) Documents cités:
- WO-A1-2016/062779
- WO-A1-2017/027165
- JP-A- 07 014 761
- JP-A- H01 119 668
- US-A- 5 354 986
- US-A- 5 522 935
- US-A1- 2007 187 615
- US-A1- 2017 207 063

## Description

### Domaine technique de l'invention

La présente invention a pour objet un procédé d'implantation ionique dans la surface d'un objet à traiter, notamment mais non exclusivement un objet en saphir synthétique, au moyen d'un faisceau d'ions. Ce procédé vise à augmenter le nombre d'ions qu'il est possible d'implanter dans la surface de l'objet à traiter et la profondeur à laquelle ces ions peuvent pénétrer dans l'objet. Le présent procédé peut s'appliquer tout aussi bien à un objet massif qu'à un objet à l'état de poudre formé de particules métalliques ou de particules céramiques.

### Arrière-plan technologique de l'invention

Les procédés d'implantation ionique consistent à bombarder la surface de l'objet à traiter par exemple au moyen d'une source d'ions mono- ou multichargés du type à résonance cyclotron électronique. Une telle installation est encore connue sous sa dénomination anglo-saxonne Electron Cyclotron Resonance ou ECR.

Une source d'ions ECR fait usage de la résonance cyclotronique des électrons pour créer un plasma. Des micro-ondes sont injectées dans un volume de gaz à basse pression destiné à être ionisé, à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules et provoquent leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

A titre d'exemple, une source d'ions multichargés du type à résonance cyclotron électronique ECR est illustrée sur la figure 1 annexée à la présente demande de brevet. Très schématiquement, une source d'ions multichargés ECR, désignée dans son ensemble par la référence numérique générale 1, comprend un étage d'injection 2 dans lequel on introduit un volume 4 de gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 14a et d'une cathode 14b entre lesquelles est appliquée une haute tension.

L'aspect du faisceau d'ions 16 produit en sortie de la source d'ions ECR 1 est illustré à la figure 2 annexée à la présente demande de brevet.

L'un des problèmes rencontré avec le procédé d'implantation ionique brièvement décrit ci-dessus réside dans le fait qu'au fur et à mesure que les ions pénètrent dans la surface de l'objet à traiter, ils créent une barrière de potentiel électrostatique qui tend à ralentir les ions qui arrivent subséquemment, ce qui limite la profondeur de pénétration de ces ions sous la surface de l'objet à traiter. En effet, plus les ions sont nombreux à être implantés à la surface de l'objet à traiter, plus le champ électrostatique que créent ces ions est élevé, et plus la surface de l'objet à traiter tend à repousser les ions qui arrivent de la source d'ions ECR, ce qui pose des problèmes d'homogénéité dans le procédé d'implantation ionique de l'objet à traiter. Dans le cas où l'objet à traiter est conducteur de l'électricité, ce problème est moins présent dans la mesure où certains au moins des électrons libres ou faiblement liés du matériau dans lequel est réalisé l'objet à traiter peuvent se recombiner avec les ions implantés. Par contre, dans le cas où l'objet à traiter est réalisé en un matériau non conducteur de l'électricité, le phénomène de recombinaison entre électrons et ions mono- ou multichargés ne se produit pas, et garantir une distribution homogène des ions dans la surface de l'objet à traiter est pratiquement impossible.

Les documents JPH01 119668 A et US 2017/0207063 A1 comptent sur l'apparition, dans la surface de l'objet à traiter, d'un courant électrique induit par le rayonnement ultraviolet au moyen duquel cette surface est éclairée, pour évacuer les charges en excès qui se sont accumulées dans l'objet à traiter Le document JP 07 014761 divulgue un procédé de neutralisation de charges électrostatiques présentes à la surface d'un objet semiconducteur par une source de rayonnement ultraviolet. Le rayonnement UV excite les gaz présents dans la chambre à vide, créant ainsi des électrons libres. Z

### Résumé de l'invention

La présente invention a pour but de résoudre les problèmes mentionnés ci-dessus ainsi que d'autres encore en procurant un procédé d'implantation d'ions à la surface d'un objet à traiter permettant notamment de garantir une répartition homogène de ces ions sur la surface de l'objet.

A cet effet, la présente invention concerne un procédé d'implantation d'ions sur une surface d'un objet à traiter selon la revendication 1 annexée à la présente demande de brevet.

Grâce à ces caractéristiques, la présente invention procure un procédé de traitement de surface d'un objet dans lequel l'objet à traiter, placé dans une chambre à vide, est éclairé au moyen d'une source de lumière ultraviolette en même temps que cet objet est bombardé au moyen d'un faisceau d'ions. Ce procédé permet ainsi de garantir une répartition plus homogène des ions à la surface de l'objet à traiter, de même qu'il permet à ces ions de pénétrer plus profondément sous la surface de l'objet à traiter. On comprend en effet que, malgré le vide assez poussé qui règne dans la chambre à vide, il subsiste néanmoins dans l'atmosphère de la chambre à vide des atomes et des molécules auxquels les photons du rayonnement ultraviolet vont arracher des électrons qui vont être attirés par le potentiel positif de la surface de l'objet à traiter et vont se recombiner avec les ions présents à la surface de cet objet de façon à annuler les charges électrostatiques. Fruit de la recombinaison entre les électrons libres qui se trouvent dans la chambre à vide et les ions implantés à la surface de l'objet à traiter, le potentiel électrostatique de l'objet à traiter peut être maintenu à des valeurs suffisamment faibles pour gêner le moins possible l'implantation de nouveaux ions et leur permettre de pénétrer suffisamment profondément sous la surface de l'objet à traiter.

Selon une forme de réalisation de l'invention, la pression atmosphérique à l'intérieur de la chambre à vide est comprise entre 10⁴ et 10⁻⁴ Pa, et de préférence entre 10⁻² Pa et 10⁻⁴ Pa.

Selon une forme de réalisation de l'invention, on injecte un gaz tel qu'un gaz noble dans la chambre à vide. En effet, en raison du vide assez poussé qui règne dans la chambre à vide dans laquelle est placé l'objet à traiter, on a constaté que les atomes et molécules qui subsistent dans cette atmosphère raréfiée ne sont pas toujours en nombre suffisant pour garantir une mise en œuvre satisfaisante du procédé selon l'invention. C'est pourquoi, à titre de variante, il est prévu d'enrichir l'atmosphère de la chambre à vide avec un gaz noble afin que le phénomène d'ionisation de cette atmosphère produise des électrons en quantités plus importantes.

### Brève description des figures

D'autres caractéristiques et avantages de la présente invention ressortiront plus clairement de la description détaillée qui suit d'un exemple de mise en œuvre du procédé selon l'invention, cet exemple étant donné à titre purement illustratif et non limitatif seulement en liaison avec le dessin annexé sur lequel :

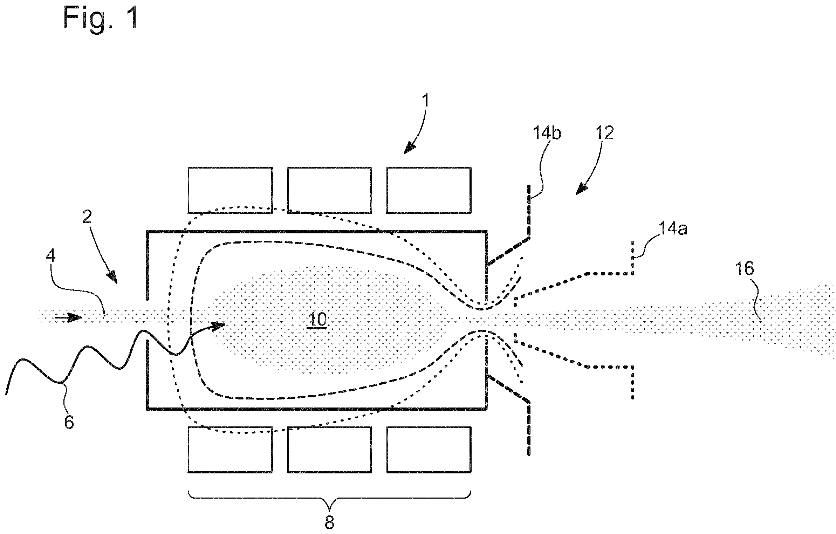

- la figure 1, déjà citée, est vue schématique d'une source d'ions du type à résonance cyclotron électronique ECR selon l'art antérieur ;
- la figure 2, déjà citée, est une vue schématique qui illustre un faisceau d'ions à la sortie de la source d'ions du type à résonance cyclotron électronique ECR illustrée à la figure 1 ;
- la figure 3 est une vue schématique d'une installation d'implantation d'ions mono- ou multichargés à la surface d'un objet à traiter et
- la figure 4 est une vue à plus grande échelle de la zone entourée d'un cercle sur la figure 3 qui illustre le phénomène de recombinaison des électrons libres qui se trouvent dans l'atmosphère de la chambre à vide avec les ions présents à la surface de l'objet à traiter.

### Description détaillée d'un mode de réalisation de l'invention

La présente invention procède de l'idée générale inventive qui consiste à placer un objet soumis à un processus d'implantation ionique dans une chambre à vide et à l'éclairer au moyen d'un rayonnement ultraviolet en même temps qu'on le bombarde avec un faisceau d'ions mono- ou multichargés. En se propageant dans la chambre à vide, les photons du rayonnement ultraviolet arrachent des électrons aux atomes et aux molécules qui subsistent dans l'atmosphère raréfiée de la chambre à vide, ces électrons libres venant ensuite se recombiner avec les ions présents à la surface de l'objet dont on traite la surface. Il est ainsi possible de contrôler le potentiel de surface de l'objet à traiter et de maintenir ce potentiel à un niveau suffisamment bas pour que les nouveaux ions qui arrivent ne soient pas exagérément freinés par la barrière de potentiel et conservent une énergie cinétique suffisante leur permettant de pénétrer en profondeur dans l'objet à traiter.

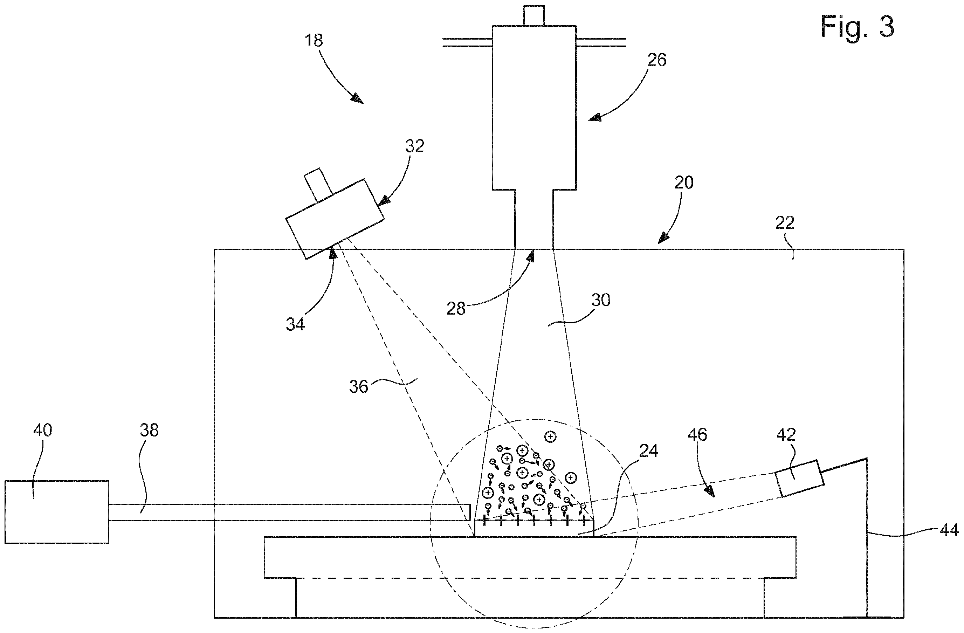

Une installation d'implantation ionique permettant la mise en œuvre du procédé selon l'invention est représentée schématiquement à la figure 3. Désignée dans son ensemble par la référence numérique générale 18, cette installation d'implantation ionique comprend une chambre à vide 20 dans l'enceinte étanche 22 de laquelle est placé un objet 24 destiné à être soumis à un procédé d'implantation ionique. L'objet 24 à traiter peut être massif ou bien se présenter à l'état de poudre. Il peut s'agir d'un matériau amorphe ou cristallin, isolant ou conducteur de l'électricité, métallique ou céramique. Dans le cas où l'objet 24 à traiter est à l'état de poudre, celle-ci sera préférentiellement agitée durant toute la durée du processus d'implantation ionique afin de s'assurer que les particules qui composent cette poudre soient exposées de manière homogène au faisceau d'implantation ionique.

Une source d'ions 26, par exemple du type à résonance cyclotron électronique ECR, est fixée de manière étanche sur l'enceinte 22 de la chambre à vide 20, en regard d'une première ouverture 28 ménagée dans cette enceinte 22. Cette source d'ions 26, d'un genre analogue à celui de la source d'ions ECR décrite ci-avant, est orientée de façon que le faisceau d'ions 30 mono- ou multichargés qu'elle produit se propage dans la chambre à vide 20 et vienne frapper la surface de l'objet 24 à traiter. Les ions mono- ou multichargés qui viennent frapper l'objet à traiter 24 pénètrent plus ou moins profondément sous la surface de cet objet 24 et s'accumulent progressivement, donnant ainsi naissance à une barrière de potentiel électrostatique qui tend à freiner et à repousser les ions qui arrivent par la suite, ce qui pose des problèmes d'inhomogénéité de la distribution des ions sur et sous la surface et dans l'épaisseur de l'objet 24 à traiter.

Pour remédier à ce problème, une source de rayonnement ultraviolet 32 est elle aussi montée de manière étanche sur l'enceinte 22 de la chambre à vide 20, face à une seconde ouverture 34 ménagée dans l'enceinte 22. Cette source de rayonnement ultraviolet 32 est orientée de façon que le rayonnement ultraviolet 36 qu'elle produit se propage dans la chambre à vide 20 et tombe sur la surface de l'objet à traiter 24 en même temps que le faisceau d'ions 30 frappe la surface de ce même objet à traiter 24.

Le vide qui règne dans l'enceinte étanche 22 de la chambre à vide 20 est relativement poussé, typiquement compris entre 10⁴ et 10⁻⁴ Pa, et de préférence entre 10⁻² Pa et 10⁻⁴ Pa. Néanmoins, malgré le vide assez poussé qui règne dans la chambre à vide 20, il subsiste dans l'atmosphère de cette chambre à vide 20 des atomes et des molécules auxquels les photons du rayonnement ultraviolet 36 vont arracher des électrons qui vont être attirés par le potentiel positif de la surface de l'objet à traiter 24 et vont se recombiner avec les ions présents à la surface de cet objet 24, de façon à annuler les charges électrostatiques. Le potentiel électrostatique de l'objet à traiter 24 peut ainsi être maintenu à des valeurs suffisamment faibles pour gêner le moins possible l'implantation de nouveaux ions et leur permettre de pénétrer suffisamment profondément sous la surface de l'objet à traiter 24.

Pour améliorer le processus d'implantation d'ions dans l'objet à traiter 24, il peut être envisagé d'enrichir l'atmosphère de la chambre à vide 20. Pour cela, la chambre à vide 20 est munie d'une valve d'admission 38 sur laquelle est raccordée une source de gaz 40, par exemple un gaz noble tel que de l'argon ou du xénon. Cette valve d'admission 38 débouche à proximité de l'objet à traiter 24, de manière à créer localement, au voisinage de l'objet à traiter 24, une légère surpression de gaz noble plus riche en atomes.

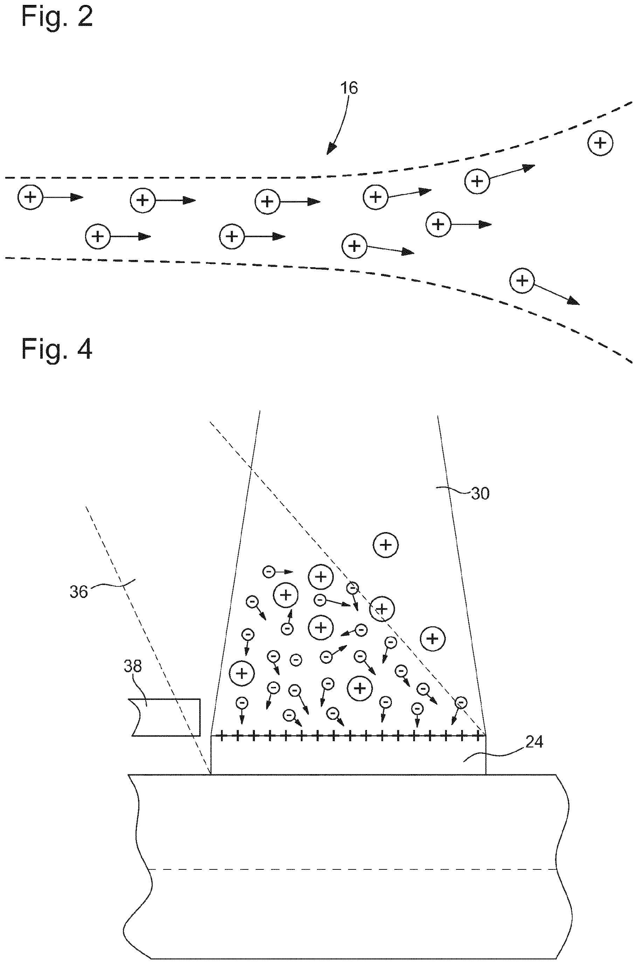

En procédant de la sorte, on enrichit l'atmosphère de la chambre à vide 20 et on augmente le nombre d'électrons arrachés aux atomes présents dans l'atmosphère qui règne dans la chambre à vide 20 (voir figure 4). Le processus de recombinaison entre les électrons dans la chambre à vide 20 et les ions à la surface de l'objet à traiter 24 est donc amplifié, ce qui permet d'abaisser encore davantage le potentiel électrique de l'objet à traiter. En effet, on s'est rendu compte avec une certaine surprise que les électrons arrachés par les photons du rayonnement ultraviolet aux atomes de gaz noble, bien qu'ils se recombinent pour partie avec des atomes ionisés du gaz noble, voire avec les ions du faisceau d'implantation ionique, se recombinent tout de même en nombre suffisamment grand avec les charges positives présentes à la surface de l'objet à traiter pour abaisser de manière sensible le potentiel électrostatique de la surface de l'objet à traiter.

Pour améliorer plus encore le processus d'implantation d'ions dans l'objet à traiter 24, il peut être envisagé de prévoir une seconde source de rayonnement ultraviolet 42. Cette seconde source de rayonnement ultraviolet 42 peut être fixée de manière étanche sur l'enceinte 22 de la chambre à vide 20, ou bien être directement installée à l'intérieur de la chambre à vide 20 en étant supportée par un pied 44. La seconde source de rayonnement ultraviolet 42 peut être orientée de façon que le rayonnement ultraviolet 46 qu'elle émet forme un angle, par exemple d'environ 90°, par rapport au rayonnement ultraviolet 36 émis par la première source de rayonnement ultraviolet 32. Avec un tel agencement des sources de rayonnement ultraviolet 32, 42, il est possible de traiter des objets 24 de plus grandes dimensions.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

On notera en particulier que la présente invention s'applique notamment au traitement de surface d'objets en saphir (naturel ou synthétique) pour la production de verres de montres. Grâce au procédé d'implantation ionique selon l'invention, on diminue significativement la quantité de lumière incidente réfléchie par de tels verres, ce qui améliore significativement la lisibilité des informations affichées par les organes indicateurs (aiguilles, quantième, décors) situés sous ces verres.

La présente invention s'applique également au traitement de surface d'objets métalliques cristallins ou amorphes ou de céramiques dont les propriétés mécaniques, notamment la résistance aux rayures, sont grandement améliorées lorsqu'on leur applique le procédé d'implantation ionique avec neutralisation de charges selon l'invention.

La présente invention s'applique aussi au traitement de surface de particules d'un matériau métallique ou céramique à l'état de poudre. Les particules de poudre métallique ou céramique obtenues grâce au procédé selon l'invention sont destinées à la fabrication de pièces massives grâce à des procédés de métallurgie des poudres tels que le procédé de moulage par injection, mieux connu sous sa dénomination anglo-saxonne Metal Injection Moulding ou MIM, le pressage ou bien encore la fabrication additive comme l'impression laser tridimensionnelle.

Selon des formes particulières de mise en œuvre du procédé selon l'invention :
- la source d'ions mono- ou multichargés est du type à résonance cyclotron électronique ECR ;
- les ions sont accélérés sous une tension comprise entre 15'000 volts et 40'000 volts ;
- le matériau à partir duquel le faisceau d'ions est produit est choisi parmi l'azote N, le carbone C, l'oxygène O, l'argon Ar, l'hélium He et le néon Ne ;
- la dose d'ions implantés est comprise entre 1*10¹⁴ ions.cm⁻² et 7.5.10¹⁷ ions.cm⁻², et de préférence entre 1*10¹⁶ ions.cm⁻² et 15*10¹⁶ ions.cm⁻² ;
- la profondeur d'implantation des ions est de 150 nm à 250 nm ;
- le matériau métallique est un métal précieux choisi parmi l'or et le platine ;
- le matériau métallique est un métal non précieux choisi parmi le magnésium, le titane et l'aluminium ;
- on agite les particules de la poudre métallique ou céramique durant toute la durée du processus d'implantation ionique ;
- la granulométrie des particules de la poudre métallique ou céramique utilisée est telle que sensiblement 50% de l'ensemble de ces particules a une dimension inférieure à 2 micromètres, la dimension des particules de la poudre métallique ou céramique utilisée n'excédant pas 60 micromètres ;
- le matériau céramique traité selon le procédé d'implantation ionique conforme à la présente invention est un carbure, en particulier un carbure de titane TiC ou un carbure de silicium SiC ;
- le matériau céramique de type carbure est bombardé au moyen d'ions azote N pour former un carbonitrure, notamment du carbonitrure de titane TiCN ou bien du carbonitrure de silicium SiCN ;
- le matériau céramique traité selon le procédé d'implantation ionique selon l'invention est un nitrure, en particulier un nitrure de silicium Si₃N4 ;
- le matériau céramique traité selon le procédé d'implantation ionique conforme à la présente invention est un oxyde, notamment de la zircone ZrO2 ou de l'alumine Al₂O₃ ;
- le matériau céramique de type oxyde est bombardé au moyen d'ions azote pour former un oxynitrure, notamment de l'oxynitrure de zircone ZrO(NO₃)₂, voire du nitrure de zirconium ZrN si l'on prolonge le bombardement ionique suffisamment longtemps, ou bien encore du nitrure d'alumine AlOxNy ;
- le matériau céramique de type oxyde est bombardé au moyen d'ions carbone pour former un carbonitrure, notamment du carbure de zircone ZrO2C, voire du carbure de zirconium ZrC ;
- le matériau céramique de type oxyde est bombardé au moyen d'ions bore pour former un oxyborure, notamment du borure de zircone ZrO2 B, voire du borure de zircone ZrB2 si l'on prolonge le bombardement ionique suffisamment longtemps L'invention est définie par les revendications.

### Nomenclature

- 1.: Source d'ions multichargés du type à résonance cyclotron électronique ECR
- 2.: Etage d'injection
- 4.: Volume de gaz à ioniser
- 6.: Onde hyperfréquence
- 8.: Etage de confinement magnétique
- 10.: Plasma
- 12.: Etage d'extraction 14a. Anode
- 14b.: Cathode
- 16.: Faisceau d'ions mono- ou multichargés
- 18.: Installation d'implantation ionique
- 20.: Chambre à vide
- 22.: Enceinte étanche
- 24.: Objet à traiter
- 26.: Source d'ions
- 28.: Première ouverture
- 30.: Faisceau d'ions mono- ou multichargés
- 32.: Source de rayonnement ultraviolet
- 34.: Seconde ouverture
- 36.: Rayonnement ultraviolet
- 38.: Valve d'admission
- 40.: Source de gaz
- 42.: Seconde source de rayonnement ultraviolet
- 44.: Pied
- 46.: Rayonnement ultraviolet

## Revendications

1. Procédé d'implantation d'ions mono- ou multichargés sur une surface d'un objet à traiter (24) placé dans une chambre à vide (20), ce procédé comprenant l'étape qui consiste simultanément :
- à injecter dans la chambre à vide (20) un faisceau d'ions (30) produit par une source d'ions (26) et à diriger ce faisceau d'ions (30) vers la surface de l'objet à traiter (24), de sorte que les ions mono- et multichargés qui viennent frapper l'objet à traiter (24) pénètrent plus ou moins profondément sous la surface de cet objet à traiter (24) et s'accumulent progressivement, donnant ainsi naissance à une barrière de potentiel électrostatique qui tend à freiner et à repousser les ions qui arrivent par la suite, et
- à éclairer la surface de l'objet à traiter (24) au moyen d'une source de rayonnement ultraviolet (32) produisant un rayonnement ultraviolet (36) qui se propage dans la chambre à vide (20) de sorte que les photons dudit rayonnement ultraviolet arrachent aux atomes et aux molécules présents dans la chambre à vide (20) des électrons qui vont être attirés par le potentiel positif de la surface de l'objet à traiter (24) et vont se recombiner avec les ions présents à la surface de l'objet à traiter (24), de façon à annuler les charges électrostatiques.

2. Procédé selon la revendication 1, dans lequel la source d'ions (26) est du type à résonance cyclotron électronique.

3. Procédé selon l'une des revendications 1 ou 2, comprenant l'étape qui consiste, durant le processus d'implantation ionique, à injecter un gaz dans la chambre à vide.

4. Procédé selon la revendication 3, dans lequel le gaz injecté est un gaz noble.

5. Procédé selon l'une des revendications 1 à 4, dans lequel la pression atmosphérique à l'intérieur de la chambre à vide (20) est comprise entre 10⁴ et 10⁻⁴ Pa et, de préférence entre 10⁻² Pa et 10⁻⁴ Pa.

6. Procédé selon l'une des revendications 1 à 5, comprenant l'étape qui consiste à éclairer la surface de l'objet à traiter (24) au moyen d'une seconde source de rayonnement ultraviolet (42) produisant un second rayonnement ultraviolet (46) qui se propage dans la chambre à vide (20) selon une direction formant un angle avec le premier rayonnement ultraviolet (36).

7. Procédé selon l'une des revendications 1 à 6, dans lequel l'objet à traiter (30) est réalisé en un matériau non conducteur de l'électricité ou semi-conducteur.

8. Procédé selon la revendication 7, dans lequel le matériau dans lequel l'objet à traiter (24) est réalisé est choisi dans le groupe formé par les saphirs naturels et synthétiques, les verres minéraux, les polymères et les céramiques.

9. Procédé selon l'une des revendications 1 à 6, dans lequel le matériau dans lequel l'objet à traiter (24) est réalisé est en un matériau conducteur de l'électricité.

10. Procédé selon la revendication 9, dans lequel le matériau dans lequel l'objet à traiter (30) est réalisé est choisi dans le groupe formé par les alliages métalliques cristallins ou amorphes, les céramiques et les métaux précieux et non précieux.

11. Procédé selon l'une des revendications 1 à 10, dans lequel les atomes qui sont implantés dans la surface de l'objet à traiter (30) au moyen de la source d'ions (26) sont choisis dans le groupe formé par l'azote N, le carbone C, l'oxygène O, l'argon Ar, l'hélium He et le néon Ne.

12. Procédé selon l'une des revendications 1 à 11, comprenant l'étape qui consiste à traiter la surface de l'objet à traiter (30) au moyen d'une dose d'implantation ionique qui se trouve dans un intervalle compris entre 1*10¹⁴ ions.cm-² et 7.5.10¹⁷ ions.cm⁻², et de préférence entre 1*10¹⁶ ions.cm⁻² et 15*10¹⁶ ions.cm⁻², et dans lequel la tension d'accélération des ions est comprise entre 7,5 kV et 40 kV.

## Patentansprüche

1. Verfahren zum Implantieren von ein- oder mehrfach geladenen Ionen auf einer Oberfläche eines zu behandelnden Objekts (24), das in einer Vakuumkammer (20) platziert ist, wobei dieses Verfahren den Schritt umfasst, der darin besteht, gleichzeitig:
- in die Vakuumkammer (20) einen von einer lonenquelle (26) produzierten lonenstrahl (30) einzuleiten und diesen lonenstrahl (30) auf die Oberfläche des zu behandelnden Objekts (24) zu richten, so dass die ein- und mehrfach geladenen Ionen, die auf dem zu behandelnden Objekt (24) aufschlagen, mehr oder weniger tief unter die Oberfläche dieses zu behandelnden Objekts (24) dringen und sich nach und nach anreichern, wodurch eine Barriere mit einem elektrostatischen Potential gebildet wird, die dazu neigt, die danach ankommenden Ionen zu bremsen und abzuweisen, und
- die Oberfläche des zu behandelnden Objekts (24) mit einer Quelle ultravioletter Strahlung (32) zu beleuchten, die eine ultraviolette Strahlung (36) erzeugt, die sich in der Vakuumkammer (20) ausbreitet, so dass die Photonen der ultravioletten Strahlung den in der Vakuumkammer (20) vorhandenen Atomen und Molekülen Elektronen entnehmen, die von dem positiven Potential der Oberfläche des zu behandelnden Objekts (24) angezogen werden und sich mit den auf der Oberfläche des zu behandelnden Objekts (24) vorhandenen Ionen derart rekombinieren, dass die elektrostatischen Ladungen annulliert werden.

2. Verfahren nach Anspruch 1, wobei die lonenquelle (26) vom Typ mit Elektronenzyklotronresonanz ist.

3. Verfahren nach einem der Ansprüche 1 oder 2, umfassend den Schritt, der darin besteht, während des lonenimplantationsverfahrens ein Gas in die Vakuumkammer einzuleiten.

4. Verfahren nach Anspruch 3, wobei eingeleitete Gas ein Edelgas ist.

5. Verfahren nach einem der Ansprüche 1 bis 4, wobei der atmosphärische Druck im Inneren der Vakuumkammer (20) zwischen 10⁴ und 10⁻⁴ Pa und vorzugsweise zwischen 10⁻² Pa und 10⁻⁴ Pa liegt.

6. Verfahren nach einem der Ansprüche 1 bis 5, umfassend den Schritt, der darin besteht, die Oberfläche des zu behandelnden Objekts (24) mit einer zweiten Quelle ultravioletter Strahlung (42) zu beleuchten, die eine zweite ultraviolette Strahlung (46) erzeugt, die sich in der Vakuumkammer (20) gemäß einer Richtung ausbreitet, die einen Winkel mit der ersten ultravioletten Strahlung (36) bildet.

7. Verfahren nach einem der Ansprüche 1 bis 6, wobei das zu behandelnde Objekt (30) aus einem nicht stromleitenden oder halbleitenden Material hergestellt ist.

8. Verfahren nach Anspruch 7, wobei das Material, aus dem das zu behandelnde Objekt (24) hergestellt ist, aus der Gruppe ausgewählt ist, die von den natürlichen und synthetischen Saphiren, den Mineralgläsern, den Polymeren und den Keramiken gebildet ist.

9. Verfahren nach einem der Ansprüche 1 bis 6, wobei das Material, aus dem das zu behandelnde Objekt (24) hergestellt ist, ein stromleitendes Material ist.

10. Verfahren nach Anspruch 9, wobei das Material, aus dem das zu behandelnde Objekt (30) hergestellt ist, aus der Gruppe ausgewählt ist, die von den kristallinen oder amorphen Metalllegierungen, den Keramiken und den Edel- und Nichtedelmetallen gebildet ist.

11. Verfahren nach einem der Ansprüche 1 bis 10, wobei die Atome, die mit der lonenquelle (26) in die Oberfläche des zu behandelnden Objekts (30) implantiert werden, aus der Gruppe ausgewählt sind, die von Stickstoff N, Kohlenstoff C, Sauerstoff O, Argon Ar, Helium He und Neon Ne gebildet ist.

12. Verfahren nach einem der Ansprüche 1 bis 11, umfassend den Schritt, der darin besteht, die Oberfläche des zu behandelnden Objekts (30) mit einer lonenimplantationsdosis zu behandeln, die sich in einem Intervall befindet, das zwischen 1*10¹⁴ lonen.cm⁻² und 7,5.10¹⁷ lonen.cm⁻² und vorzugsweise zwischen 1*10¹⁶ lonen.cm⁻² und 15*10¹⁶ lonen.cm⁻² liegt und wobei die Beschleunigungsspannung der Ionen zwischen 7,5 kV und 40 kV liegt.

## Claims

1. Method for implanting mono- or multi-charged ions on a surface of an object to be treated (24) placed in a vacuum chamber (20), this method comprising the step that consists simultaneously of:
- injecting into the vacuum chamber (20) a beam of ions (30) produced by a source of ions (26) and directing this beam of ions (30) towards the surface of the object to be treated (24), so that the mono- or multi-charged ions that strike the object to be treated (24) penetrate more or less deeply under the surface of this object to be treated (24) and accumulate progressively, thus giving rise to an electrostatic potential barrier that tends to restrict and repel the ions that arrive subsequently, and
- illuminating the surface of the object to be treated (24) by means of a source of ultraviolet radiation (32) producing ultraviolet radiation (36) that propagates in the vacuum chamber (20), so that the photons of said ultraviolet radiation will extract from atoms and molecules that remain in the atmosphere of the vacuum chamber electrons that will be attracted by the positive potential of the surface of the object to be treated (24) and will recombine with the ions present on the surface of the object to be treated (24), so as to cancel out the electrostatic charges.

2. Method according to claim 1, wherein the source of ions (26) is of the electron cyclotron resonance type.

3. Method according to either claim 1 or claim 2, comprising the step of injecting a gas into the vacuum chamber during the ion implantation process.

4. Method according to claim 3, wherein the injected gas is a noble gas.

5. Method according to any of claims 1 to 4, wherein the atmospheric pressure inside the vacuum chamber (20) is between 10⁴ and 10⁻⁴ Pa and preferably between 10⁻² Pa and 10⁻⁴ Pa.

6. Method according to any of claims 1 to 5, comprising the step of illuminating the surface of the object to be treated (24) is illuminated by means of a second source of ultraviolet radiation (42) producing a second ultraviolet radiation (46) that propagates in the vacuum chamber (20) in a direction forming an angle with the first ultraviolet radiation (36).

7. Method according to any of claims 1 to 6, wherein the object to be treated (30) is produced from a material that does not conduct electricity or is semiconductive.

8. Method according to claim 7, wherein the material from which the object to be treated (24) is produced is chosen from the group formed by natural and synthetic sapphires, mineral glasses, polymers and ceramics.

9. Method according to any of claims 1 to 6, wherein the material from which the object to be treated (24) is produced is an electrically conductive material.

10. Method according to claim 9, wherein the material from which the object to be treated (30) is produced is chosen from the group formed by crystalline or amorphous metal alloys, ceramics and precious and non-precious metals.

11. Method according to any of claims 1 to 10, wherein the atoms that are implanted in the surface of the object to be treated (24) by means of the source of ions (26) are chosen from the group formed by nitrogen N, carbon C, oxygen O, argon Ar, helium He and neon Ne.

12. Method according to any of claims 1 to 11, comprising the step of treating the surface of the object to be treated (24) by means of an ion implantation dose that is situated in a range lying between 1*10¹⁴ ions.cm⁻² and 7.5.10¹⁷ ions.cm⁻², and preferably between 1*10¹⁶ ions.cm⁻² and 15*10¹⁶ ions.cm⁻², and wherein the acceleration voltage of the ions is between 7.5 kV and 40 kV.
